# EUROPEAN PATENT APPLICATION

(11) **EP 3 920 128 A1**
(43) Date of publication of application: **08.12.2021**
(21) Application number: 20194499.8
(22) Date of filing: 04.09.2020
(51) Int. Cl.: G06Q 50/30

(54) **OPERATIONAL DESIGN DOMAINS IN AUTONOMOUS DRIVING**

(30) Priority: 03.06.2020 GB 202008357
(71) Applicant: Five AI Limited, Temple Meads, Bristol BS1 6QS (GB)
(72) Inventor: REDFORD, John, Bristol, BS1 6QS (GB); WHITESIDE, Iain, Bristol, BS1 6QS (GB)
(74) Representative: Woodhouse, Thomas Duncan

(57) **Abstract**

A computer system for analysing driving scenes in relation to an autonomous vehicle (AV) operational design domain (ODD), the computer system comprising: an input configured to receive a definition of the ODD in a formal ontology language; a scene processor configured to receive data of a driving scene and extract a scene representation therefrom, the data comprising an ego trace, at least one agent trace, and environmental data about an environment in which the traces were captured or generated, wherein the scene representation is an ontological representation of both static and dynamic elements of the driving scene extracted from the traces and the environmental data, and expressed in the same formal ontology language as the ODD; and a scene analyzer configured to match the static and dynamic elements of the scene representation with corresponding elements of the ODD, and thereby determine whether or not the driving scene is within the defined ODD.

## Description

### Technical field

The present technology leverages the concept of operational design domains (ODDs) in autonomous driving. The technology can be applied both in a simulation and testing context, but also in an online context, to provide an assessment of the capability of an autonomous vehicle decision stack.

### Background

A core challenge in autonomous driving is understanding the extent of an autonomous vehicle's (AV's) capability. In autonomous driving parlance, this may be characterized as an Operational Design Domain (ODD) problem. For example, the SAE J3016 Information Report defines an ODD as:
*"Operating conditions under which a given driving automation system [ADS] or feature thereof is specifically designed to function, including, but not limited to, environmental, geographical, and time-of-day restrictions, and*/*or the requisite presence or absence of certain traffic or roadway characteristics. "*

SAE J3016 is the origin of Levels 0 to 5 of autonomous driving. The aim of the ODD is to characterize the (possible) technical limitations of an ADS or feature (as opposed to mere regulatory or social restrictions). Examples of ODDs given in SAE J3016 include:
*"A level 4 ADS-DV [Dedicated Vehicle] designed to operate exclusively within a corporate campus where it picks up and discharges passengers along a specific route specified by the ADS-DV dispatcher.*
*"A level 4 ADS-DV designed to operate exclusively within a geographically prescribed central business district where it delivers supplies using roads (but not necessarily routes) specified by the ADS-DV dispatcher"*

As the terminology is used herein, it not necessarily the case that AV or feature can never operate safely and effectively outside of its ODD, however, the ability to operate outside of the ODD cannot be guaranteed.

Taking geographic restrictions on the ODD as an example, an ADS might only be designed to operate within a particular, pre-mapped geographic area, e.g. within the ground of an airport or a particular urban center. Basic geographic restrictions like these could be enforced using geo-fencing or similar technology to disengage the ADS outside of the defined area, forcing driver intervention in that event. Other restrictions on the ODD, such as to certain weather conditions or to road driving with clearly discernible lane markings, could be similarly enforced.

### Summary

It is relatively straightforward to apply the concept of an ODD to simple examples like those above. However, one issue that arises is the potentially complex interaction between different contributing factors, e.g. to take an example that is still relatively simple, it might be that an ADS is capable of operating on both marked and unmarked roads in clear weather conditions, but can only operate on roads with clear markings in light-to-medium rain, and is not capable of operating at all in heavy rain. Another issue is precision -taking adaptive cruise control as an example, it may be that a particular ACC component is only designed to operate within a certain minimum headway to a forward vehicle, which might, for example, be dependent on weather or lighting conditions. Precise, detailed characterization of an ODD is difficult within the existing framework. Moreover, the limits of an ODD can change over time e.g. because further testing demonstrates an existing ADS to be more capable of accommodating a greater range of operating conditions, or because the ADS has been developed further, or a combination of both - compounding these issues further.

As the complexity scales, it becomes harder and harder to precisely characterize an ODD within the existing, descriptive SAE J3016 framework. The existing framework is also heavily reliant on the skill and knowledge of individual experts or teams to correctly and precisely characterize the ODDs their systems or features and, as the complexity increases, the scope for errors also increase. Mischaracterizing an ODD can have disastrous, even fatal consequences; it is a safety-critical task.

The present techniques formalize the concept of an ODD within a formal ontology. This allows precise assessments to made as to the capability of an AV stack, and in particular a precise assessment to be made as to whether or not a given driving scene is within or outside of a defined ODD. Correspondence between a scene (real or simulated) and ODD can be determined precisely and efficiently because a common ontology language is used to represent both.

A first aspect herein provides a computer system for analysing driving scenes in relation to an autonomous vehicle (AV) operational design domain (ODD), the computer system comprising:
an input configured to receive a definition of the ODD in a formal ontology language;
a scene processor configured to receive data of a driving scene and extract a scene representation therefrom, the data comprising an ego trace, at least one agent trace, and environmental data about an environment in which the traces were captured or generated, wherein the scene representation is an ontological representation of both static and dynamic elements of the driving scene extracted from the traces and the environmental data, and expressed in the same formal ontology language as the ODD; and
a scene analyzer configured to match the static and dynamic elements of the scene representation with corresponding elements of the ODD, and thereby determine whether or not the driving scene is within the defined ODD.

In embodiments, the computer system may comprise a simulator configured to simulate the driving scene, the traces being simulated traces of the simulated driving scene.

The simulator may be configured to provide simulated perception inputs to a full or partial AV stack, and simulate the ego trace to reflect decisions taken by the AV stack in response to the simulated perception inputs.

The computer system may comprise a scene extraction component configured to extract the data of the driving scene from real-world sensor data.

The scene extraction component may be configured to extract the data of the driving scene using one or more perception models applied to the sensor data and/or based on manual annotation inputs.

The scene analyser may be configured to identify an individual element or a combination of elements of the scene representation as outside of the ODD.

The computer system may comprise a user interface configured to display the scene representation with a visual indication of any individual element or combination of elements identified to be outside of the ODD.

The computer system may comprise an input configured to receive sensor data in one or more data streams, the computer system configured to operate in real-time.

The computer system may be embodied in a physical autonomous vehicle for making an online determination as to whether or not the physical autonomous vehicle is within the ODD.

The AV stack may include an online scene analyzer configured to make a separate online determination as to whether or not the driving scene is within the ODD, based on the simulated perception inputs; wherein the computer system may be configured to determine whether or not the determination by the scene analyzer matches the online determination within the AV stack or sub-stack.

The AV stack may be a partial AV stack, wherein the simulator may provide ground truth perception inputs, but the perception inputs inputted to the partial AV stack contain perception errors sampled from one or more perception error models.

In the event that the online determination as to whether the scene is within the ODD does not match the determination by the scene analyzer, the computer system may be configured to repeat the simulation based on the ground truth perception inputs directly, without any sampled perception errors, to ascertain whether or not the mismatch was caused by the perception errors.

In the event the scene analyzer determines the scene is outside of the ODD, the computer system may be configured to ascertain whether or not a decision(s) within the AV stack caused the scene to be outside of the ODD.

In the event the scene analyzer determines the scene is outside of the ODD, the computer system may be configured to repeat the simulation based on the ground truth perception inputs directly, without any sampled perception errors, to ascertain whether or not the perception errors caused the scene to be outside of the ODD.

The computer system may comprise a test oracle configured to apply a set of numerical performance metrics to score the performance of the AV stack on the simulated driving scene.

The test oracle may be configured to select at least one of the set of numerical performance metrics, and a set of thresholds applied to the numerical performance metrics, based on one or more of the static and/or dynamic elements of the scene representation.

A further aspect herein provides a computer-implemented method of analysing driving scenes in relation to an autonomous vehicle (AV) operational design domain (ODD), the method comprising:
receiving a definition of the ODD in a formal ontology language;
receiving data of a driving scene and extracting a scene representation therefrom, the data comprising an ego trace, at least one agent trace, and environmental data about an environment in which the traces were captured or generated, wherein the scene representation is an ontological representation of both static and dynamic elements of the driving scene extracted from the traces and the environmental data, and expressed in the same formal ontology language as the ODD; and
matching the static and dynamic elements of the scene representation with corresponding elements of the ODD, and thereby determining whether or not the driving scene is within the defined ODD.

The method may comprise the steps of using the defined ODD to formulate a testing strategy for testing a range of driving scenarios across the ODD, and selecting driving scenarios for simulation in accordance with the testing strategy.

A further aspect herein provides a computer program comprising program instructions for programming a computer system to implement the components or method of any preceding claim.

### Brief Description of Figures

For a better understanding of the present disclosure, and to show how embodiments of the same may be carried into effect, reference is made by way of example only to the following figures in which:
Figure 1 shows a schematic function block diagram of an autonomous vehicle stack;
Figure 2 shows a schematic block diagram of a testing pipeline;
Figure 2A shows further details of a possible implementation of the testing pipeline;
Figure 3 shows further details of a testing pipeline for applying an ODD assessment to simulated traces;
Figure 4 shows further details of a testing pipeline for applying an ODD assessment to real-world traces, in an offline context;
Figure 5 shows an AV stack equipped with online ODD assessment capability;
Figure 5A shows further details of a testing pipeline for testing the online ODD assessment capability of the stack of Figure 5;
Figure 6 shows how testing metrics and/or thresholds appropriate to a scene may be selected based on an ontological representation of the scene;
Figures 7A-7C show example screens from a testing interface that might be rendered in the systems of Figures 3 or 4;
Figures 8A shows an ontology editing interface;
Figure 8B shows an ODD editing interface;
Figure 8C shoes a scene editing interface
Figure 8D shows an ODD editing interface on which internal inconsistencies in an ODD definition have been visually marked;
Figure 9 illustrates the conversion of driving data to a formal scene representation; and
Figure 10 shows a scene view interface on which an element of a formal scene representation has been marked as taking the scene outside of an ODD.

### Detailed Description

To provide some further context to the above discussion, it has been estimated that, in order for AV to achieve a level of safety that matches that of human drivers, a maximum of 1 error per 10^7 autonomous driving decisions is permissible. This level of safety must be exhibited across the entire ODD, which in turn requires rigorous testing across the entire ODD. The present disclosure recognizes that a barrier in this context is the ability to precisely define and apply an ODD within the existing frameworks.

To address these issues, a formal and hierarchically-structured framework for characterising ODDs is provided herein. A core element is the ability to precisely define an ODD in terms of a formal "ontology", and then apply that definition to a real-world or simulated driving scenario to determine whether the driving scenario as within or outside of the defined ODD.

In computer science, an ontology is a formal representation of domain knowledge via a defined set of concepts and relationships between those concepts. An ontology language is a formal language used to construct ontologies.

Ontologies have been applied in other contexts in the field of autonomous driving, as a way to formally represent driving scenarios. The terms "scene" and "scenario" are used synonymously in this context. The term "scenario" is used in relation to both the input to the simulator (the scenario description 201) and the output of the simulator (which includes, among other things, the ego trace 2142a). It will be clear in context which is referred to. Various autonomous driving ontologies exist for the purpose of formally representing both static and dynamic elements of driving scenarios. Existing work has applied an ontology framework to scene understanding as well as scene generation (in a simulation context).

A core principle herein is the extension of such ontological frameworks to formally define ODDs as well as to formally represent scenarios. By using the same ontological framework to formally and precisely define and ODD as is used to formally represent driving scenarios, it becomes possible to efficiently and robustly analyse a driving scenario in relation to a defined ODD, and in particular to automatically classify any given driving scenario as within or outside of the defined ODD.

A common ontology language is used to represent both the ODD and driving scenarios. The ODD is a precisely defined subset of the ontology, and the task is one of determining whether or not a given scene is within or outside of that subset.

This is described in further detail below, but first some key terminology is discussed.

A "scenario" can be real or simulated and will typically involve at least one agent moving within an environment (e.g. within a particular road layout), and potentially in the presence of one or more other agents. A "trace" is a history of an agent's (or actor's) location and motion over the course of a scenario. There are many ways a trace can be represented. Trace data will typically include spatial and motion data of an agent within an environment. The term is used in relation to both real scenarios (with physical traces) and simulated scenarios (with simulated traces). An "ontological representation" of a scenario (scenario representation) is a higher-level representation of the scenario within a formal ontology, which can include both environmental elements, e.g. an ontological representation of the road layout, and dynamic elements, e.g. an ontological representation of an agent's motion derived from its trace. Again, both real and simulated scenarios can be represented ontologically.

The present techniques can be applied to analyse both real and simulated scenarios in relation to a formal ODD, and in particular to classify both real and simulated scenarios as within or outside of a formal ODD.

The present techniques can be applied offline, but also online within an AV stack to make an online assessments as to whether a current scene is within a formal ODD. In the case that a real-world AV finds itself outside of its ODD, that could trigger an appropriate event within the stack, e.g. to alert a driver that manual intervention is required, to implement a failover routine.

A typical AV stack includes perception, prediction, planning and control (sub)systems. The term "planning" is used herein to refer to autonomous decision-making capability (such as trajectory planning) whilst "control" is used refer to the generation of control signals for carrying out autonomous decisions. The extent to which planning and control are integrated or separable can vary significantly between different stack implementations - in some stacks, these may be so tightly coupled as to be indistinguishable (e.g. such stacks could plan in terms of control signals directly), whereas other stacks may be architected in a way that draws a clear distinction between the two (e.g. with planning in terms of trajectories, and with separate control optimizations to determine how best to execute a planned trajectory at the control signal level). Unless otherwise indicated, the planning and control terminology used herein does not imply any particular coupling or separation of those aspects. An example form of AV stack will now be described in further detail, to provide relevant context to the subsequent description.

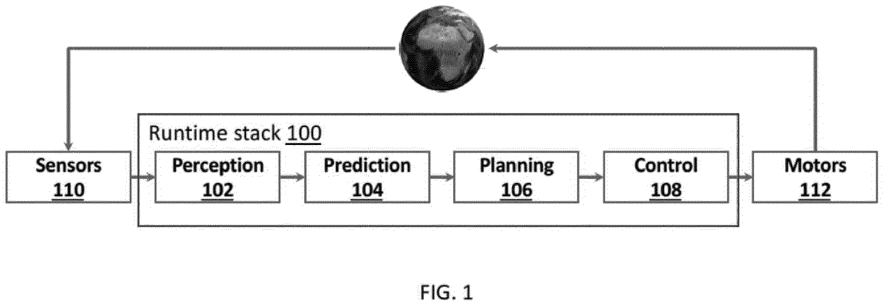

Figure 1 shows a highly schematic block diagram of a runtime stack 100 for an autonomous vehicle (AV), also referred to herein as an ego vehicle (EV). The run time stack 100 is shown to comprise a perception system 102, a prediction system 104, a planner 106 and a controller 108.

In a real-wold context, the perception system 102 would receive sensor outputs from an on-board sensor system 110 of the AV and uses those sensor outputs to detect external agents and measure their physical state, such as their position, velocity, acceleration etc. The on-board sensor system 110 can take different forms but generally comprises a variety of sensors such as image capture devices (cameras/optical sensors), LiDAR and/or RADAR unit(s), satellite-positioning sensor(s) (GPS etc.), motion sensor(s) (accelerometers, gyroscopes etc.) etc., which collectively provide rich sensor data from which it is possible to extract detailed information about the surrounding environment and the state of the AV and any external actors (vehicles, pedestrians, cyclists etc.) within that environment. The sensor outputs typically comprise sensor data of multiple sensor modalities such as stereo images from one or more stereo optical sensors, LiDAR, RADAR etc. Stereo imaging may be used to collect dense depth data, with LiDAR/RADAR etc. proving potentially more accurate but less dense depth data. More generally, depth data collection from multiple sensor modalities may be combined in a way that preferably respects their respective levels of uncertainty (e.g. using Bayesian or non-Bayesian processing or some other statistical process etc.). Multiple stereo pairs of optical sensors may be located around the vehicle e.g. to provide full 360° depth perception.

The perception system 102 comprises multiple perception components which co-operate to interpret the sensor outputs and thereby provide perception outputs to the prediction system 104. External agents may be detected and represented probabilistically in a way that reflects the level of uncertainty in their perception within the perception system 102.

In a simulation context, depending on the nature of the testing - and depending, in particular, on where the stack 100 is sliced - it may or may not be necessary to model the on-board sensor system 100. With higher-level slicing, simulated sensor data is not required therefore complex sensor modelling is not required.

The perception outputs from the perception system 102 are used by the prediction system 104 to predict future behaviour of external actors (agents), such as other vehicles in the vicinity of the AV.

Predictions computed by the prediction system 104 are provided to the planner 106, which uses the predictions to make autonomous driving decisions to be executed by the AV in a given driving scenario. A scenario is represented as a set of scenario description parameters used by the planner 106. A typical scenario would define a drivable area and would also capture predicted movements of any external agents (obstacles, form the AV's perspective) within the drivable area. The driveable area can be determined using perception outputs from the perception system 102 in combination with map information, such as an HD (high-definition) map.

A core function of the planner 106 is the planning of trajectories for the AV (ego trajectories) taking into account predicted agent motion. This may be referred to as maneuver planning. A trajectory is planned in order to carry out a desired goal within a scenario. The goal could for example be to enter a roundabout and leave it at a desired exit; to overtake a vehicle in front; or to stay in a current lane at a target speed (lane following). The goal may, for example, be determined by an autonomous route planner (not shown).

The controller 108 executes the decisions taken by the planner 106 by providing suitable control signals to an on-board actor system 112 of the AV. In particular, the planner 106 plans manoeuvres to be taken by the AV and the controller 108 generates control signals in order to execute those manoeuvres.

### Simulation context

To provide context to the simulation applications described below, there is first described a testing pipeline that can be used to test the performance of all or part of an autonomous vehicle (AV) runtime stack. The testing pipeline is highly flexible and can accommodate many forms of AV stack, operating at any level of autonomy. Note, the term autonomous herein encompasses any level of full or partial autonomy, from Level 1 (driver assistance) to Level 5 (complete autonomy).

However a stack is "sliced" for the purpose of testing, the idea of simulation-based testing for autonomous vehicles is to run a simulated driving scenario that an ego agent must navigate, often within a static drivable area (e.g. a particular static road layout) but typically in the presence of one or more other dynamic agents such as other vehicles, bicycles, pedestrians etc. (also referred to as actors or external agents). Simulated perception inputs are derived from the simulation, which in turn feed into the stack or sub-stack under testing, where they are processed in exactly the same way as corresponding physical perception inputs would be, so as to drive autonomous decision making within the (sub-)stack. The ego agent is, in turn, caused to carry out those decisions, thereby simulating the behaviours or a physical autonomous vehicle in those circumstances. The simulated perception inputs changes as the scenario progresses, which in turn drives the autonomous decision making within the (sub-) stack being tested. The results can be logged and analysed in relation to safety and/or other performance criteria. Note the term perception input as used herein can encompass "raw" or minimally-processed sensor data (i.e. the inputs to the lowest-level perception components) as well as higher-level outputs (final or intermediate) of the perception system that serve as inputs to other component(s) of the stack (e.g. other perception components and/or prediction/planning).

Slicing refers to the set or subset of stack components subject to testing. This, in turn, dictates the form of simulated perception inputs that need to be provided to the (sub-)stack, and the way in which autonomous decisions.

For example, testing of a full AV stack, including perception, would typically involve the generation of sufficiently realistic simulated sensor inputs (such as photorealistic image data and/or equally realistic simulated lidar/radar data etc.) that, in turn, can be fed to the perception subsystem and processed in exactly the same way as real sensor data. The resulting outputs of the perception system would, in turn, feed the higher-level prediction and planning system, testing the response of those components to the simulated sensor inputs. In place of the physical actor system, an ego vehicle dynamics model could then be used to translate the resulting control signals into realistic motion of an "ego agent" within the simulation, thereby simulating the response of an ego vehicle to the control signal.

By contrast, so-called "planning-level" simulation would essentially bypass the prediction system. A simulator would provide simpler, higher-level simulated perception inputs that can be fed directly to the prediction and planning components, i.e. rather than attempting to simulate the sensor inputs to the perception system, the simulator would instead simulate the outputs of the perception system which are then inputted to the prediction/planning systems directly. As a general rule, the "lower down" the stack is sliced, the more complex the required simulated perception inputs (ranging from full sensor modelling at one extreme to simple simulated fused location/orientation measurements etc. at the other, which can be derived straightforwardly using efficient techniques like ray tracing).

Between those two extremes, there is scope for many different levels of input slicing, e.g. testing only a subset of the perception system, such as "later" perception components, i.e., components such as filters or fusion components which operate on the outputs from lower-level perception components (such as object detectors, bounding box detectors, motion detectors etc.).

In any of the above, for stacks where control is separable from planning, control could also be bypassed (output slicing). For example, if a manoeuvre planner of the stack plans in terms of trajectories that would feed into a control system within the full stack, for the purpose of the simulation, it could simply be assumed that the ego agent follows each planned trajectory exactly, which bypasses the control system and removes the need for more in-depth vehicle dynamics modelling. This may be sufficient for testing certain planning decisions.

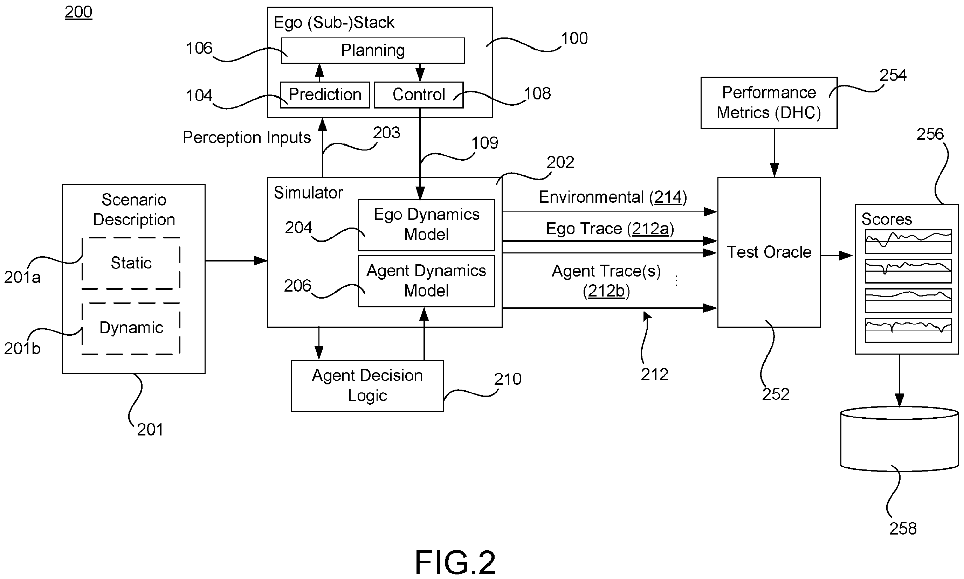

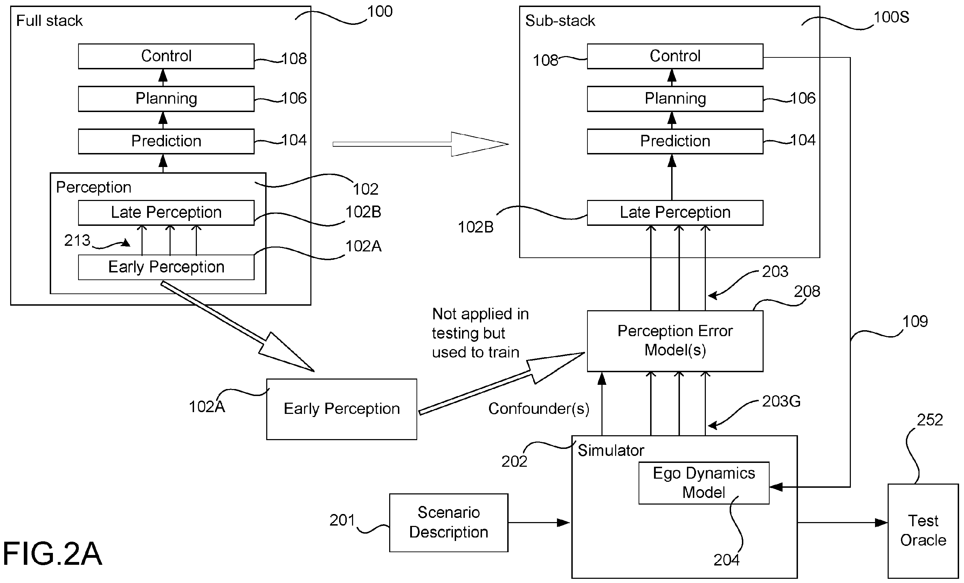

Figure 2 shows a schematic block diagram of a testing pipeline 200. The testing pipeline 200 is shown to comprise a simulator 202 and a test oracle 252. The simulator 202 runs simulations for the purpose of testing all or part of an AV run time stack.

By way of example only, the description of the testing pipeline 200 makes reference to the runtime stack 100 of Figure 1 to illustrate some of the underlying principles by example. As discussed, it may be that only a sub-stack of the run-time stack is tested, but for simplicity, the following description refers to the AV stack 100 throughout; noting that what is actually tested might be only a subset of the AV stack 100 of Figure 1, depending on how it is sliced for testing. In Figure 2, reference numeral 100 can therefore denote a full AV stack or only sub-stack depending on the context.

Figure 2 shows the prediction, planning and control systems 104, 106 and 108 within the AV stack 100 being tested, with simulated perception inputs 203 fed from the simulator 202 to the stack 100. However, this does not necessarily imply that the prediction system 104 operates on those simulated perception inputs 203 directly (though that is one viable slicing, in which case the simulated perception inputs 203 would correspond in form to the final outputs of the perception system 102). For instance, in the example depicted in Figure 2A and described in detail below, the AV stack 100 is sliced such that a subset of late perception components 102B (only) are included in a tested sub-stack 100S, together with the prediction, planning and control components 104, 106 and 108 (in this case, the simulated perception inputs 203 would correspond to the outputs of the remaining, earlier perception components that are not implemented with the stack 100 during testing). Where the full perception system 102 is implemented in the stack being tested (or, at least, where one or more lower-level perception components that operate on raw sensor data are included), then the simulated perception inputs 203 would comprise simulated sensor data.

The simulated perception inputs 203 are used as a basis for prediction and, ultimately, decision-making by the planner 108. The controller 108, in turn, implements the planner's decisions by outputting control signals 109. In a real-world context, these control signals would drive the physical actor system 112 of AV. The format and content of the control signals generated in testing are the same as they would be in a real-world context. However, within the testing pipeline 200, these control signals 109 instead drive the ego dynamics model 204 to simulate motion of the ego agent within the simulator 202.

To the extent that external agents exhibit autonomous behaviour/decision making within the simulator 202, some form of agent decision logic 210 is implemented to carry out those decisions and drive external agent dynamics within the simulator 202 accordingly. The agent decision logic 210 may be comparable in complexity to the ego stack 100 itself or it may have a more limited decision-making capability. The aim is to provide sufficiently realistic external agent behaviour within the simulator 202 to be able to usefully test the decision-making capabilities of the ego stack 100. In some contexts, this does not require any agent decision making logic 210 at all (open-loop simulation), and in other contexts useful testing can be provided using relatively limited agent logic 210 such as basic adaptive cruise control (ACC). Similar to the ego stack 100, any agent decision logic 210 is driven by outputs from the simulator 202, which in turn are used to derive inputs to the agent dynamics models 206 as a basis for the agent behaviour simulations.

A simulation of a driving scenario is run in accordance with a scenario description 201, having both static and dynamic layers 201a, 201b.

The static layer 201a defines static elements of a scenario, which would typically include a static road layout.

The dynamic layer 201b defines dynamic information about external agents within the scenario, such as other vehicles, pedestrians, bicycles etc. The extent of the dynamic information provided can vary. For example, the dynamic layer 201b may comprise, for each external agent, a spatial path to be followed by the agent together with one or both of motion data and behaviour data associated with the path.

In simple open-loop simulation, an external actor simply follows the spatial path and motion data defined in the dynamic layer that is non-reactive i.e. does not react to the ego agent within the simulation. Such open-loop simulation can be implemented without any agent decision logic 210.

However, in "closed-loop" simulation, the dynamic layer 201b instead defines at least one behaviour to be followed along a static path (such as an ACC behaviour). In this, case the agent decision logic 210 implements that behaviour within the simulation in a reactive manner, i.e. reactive to the ego agent and/or other external agent(s). Motion data may still be associated with the static path but in this case is less prescriptive and may for example serve as a target along the path. For example, with an ACC behaviour, target speeds may be set along the path which the agent will seek to match, but the agent decision logic 110 might be permitted to reduce the speed of the external agent below the target at any point along the path in order to maintain a target headway from a forward vehicle.

The output of the simulator 202 for a given simulation includes an ego trace 212a of the ego agent and one or more agent traces 212b of the one or more external agents (traces 212).

A trace is a complete history of an agent's behaviour within a simulation having both spatial and motion components. For example, a trace may take the form of a spatial path having motion data associated with points along the path such as speed, acceleration, jerk (rate of change of acceleration), snap (rate of change of jerk) etc.

Additional information is also provided to supplement and provide context to the traces 212. Such additional information is referred to as "environmental" data 214 which can have both static components (such as road layout) and dynamic components (such as weather conditions to the extent they vary over the course of the simulation).

To an extent, the environmental data 214 may be "passthrough" in that it is directly defined by the scenario description 201 and is unaffected by the outcome of the simulation. For example, the environmental data 214 may include a static road layout that comes from the scenario description 201 directly. However, typically the environmental data 214 would include at least some elements derived within the simulator 202. This could, for example, include simulated weather data, where the simulator 202 is free to change weather conditions as the simulation progresses. In that case, the weather data may be time-dependent, and that time dependency will be reflected in the environmental data 214.

The test oracle 252 receives the traces 212 and the environmental data 214, and scores those outputs against a set of predefined numerical performance metrics 254. The performance metrics 254 encode what may be referred to herein as a "Digital Highway Code" (DHC). Some examples of suitable performance metrics are given below.

The scoring is time-based: for each performance metric, the test oracle 252 tracks how the value of that metric (the score) changes over time as the simulation progresses. The test oracle 252 provides an output 256 comprising a score-time plot for each performance metric. The metrics 254 are informative to an expert and the scores can be used to identify and mitigate performance issues within the tested stack 100.

### Perception error models

Figure 2A illustrates a particular form of slicing and uses reference numerals 100 and 100S to denote a full stack and sub-stack respectively. It is the sub-stack 100S that would be subject to testing within the testing pipeline 200 of Figure 2.

A number of "later" perception components 102B form part of the sub-stack 100S to be tested and are applied, during testing, to the simulated perception inputs 203. The later perception components 102B could, for example, include filtering or other fusion components that fuse perception inputs from multiple earlier perception components.

In the full stack 100, the later perception component 102B would receive actual perception inputs 213 from earlier perception components 102A. For example, the earlier perception components 102A might comprise one or more 2D or 3D bounding box detectors, in which case the simulated perception inputs provided to the late perception components could include simulated 2D or 3D bounding box detections, derived in the simulation via ray tracing. The earlier perception components 102A would generally include component(s) that operate directly on sensor data.

With this slicing, the simulated perception inputs 203 would correspond in form to the actual perception inputs 213 that would normally be provided by the earlier perception components 102A. However, the earlier perception components 102A are not applied as part of the testing, but are instead used to train one or more perception error models 208 that can be used to introduce realistic error, in a statistically rigorous manner, into the simulated perception inputs 203 that are fed to the later perception components 102B of the sub-stack 100 under testing.

Such perception error models may be referred to as Perception Statistical Performance Models (PSPMs) or, synonymously, "PRISMs". Further details of the principles of PSPMs, and suitable techniques for building and training them, may be found in European Patent Application No. 20168311.7, incorporated herein by reference in its entirety. The idea behind PSPMs is to efficiently introduce realistic errors into the simulated perception inputs provided to the sub-stack 102B (i.e. that reflect the kind of errors that would be expected were the earlier perception components 102A to be applied in the real-world). In a simulation context, "perfect" ground truth perception inputs 203G are provided by the simulator, but these are used to derive more realistic perception inputs 203 with realistic error introduced by the perception error models(s) 208.

As described in the aforementioned reference, a PSPM can be dependent on one or more variables representing physical condition(s) ("confounders"), allowing different levels of error to be introduced that reflect different possible real-world conditions. Hence, the simulator 202 can simulate different physical conditions (e.g. different weather conditions) by simply changing the value of a weather confounder(s), which will, in turn, change how perception error is introduced.

The later perception components 102b within the sub-stack 100S process the simulated perception inputs 203 in exactly the same way as they would process the real-world perception inputs 213 within the full stack 100, and their outputs, in turn, drive prediction, planning and control.

### Testing metrics:

The performance metrics 254 can be based on various factors, such as distance speed etc. In the described system, these can mirror a set of applicable road rules, such as the Highway Code applicable to road users in the United Kingdom. The term "Digital Highway Code" (DHC) may be used in relation to the set of performance metrics 254, however, this is merely a convenient shorthand and does not imply any particular jurisdiction. The DHC can be made up of any set of performance metrics 254 that can assess driving performance numerically. As noted, each metric is numerical and time-dependent. The value of a given metric at a partial time is referred to as a score against that metric at that time.

Relatively simple metrics include those based on vehicle speed or acceleration, jerk etc., distance to another agent (e.g. distance to closest cyclist, distance to closest oncoming vehicle, distance to curb, distance to centre line etc.). A comfort metric could score the path in terms of acceleration or a first or higher order time derivative of acceleration (jerk, snap etc.). Another form of metric measures progress to a defined goal, such as reaching a particular roundabout exit. A simple progress metric could simply consider time taken to reach a goal. More sophisticated metrics progress metric quantify concepts such as "missed opportunities", e.g. in a roundabout context, the extent to which an ego vehicle is missing opportunities to join a roundabout.

For each metric, as associated "failure threshold" is defined. An ego agent is said to have failed that metric if its score against that metric drops below that threshold.

Not all of the metrics 254 will necessarily apply to a given scenario. For example, a subset of the metrics 254 may be selected that are applicable to a given scenario. An applicable subset of metrics can be selected by the test oracle 252 in dependence on one or both of the environmental data 214 pertaining to the scenario being considered, and the scenario description 201 used to simulate the scenario. For example, certain metric may only be applicable to roundabouts or junctions etc., or to certain weather or lighting conditions.

One or both of the metrics 254 and their associated failure thresholds may be adapted to a given scenario. For example, speed-based metrics and/or their associated failure metrics may be adapted in dependence on an applicable speed limit but also weather/lighting conditions etc.

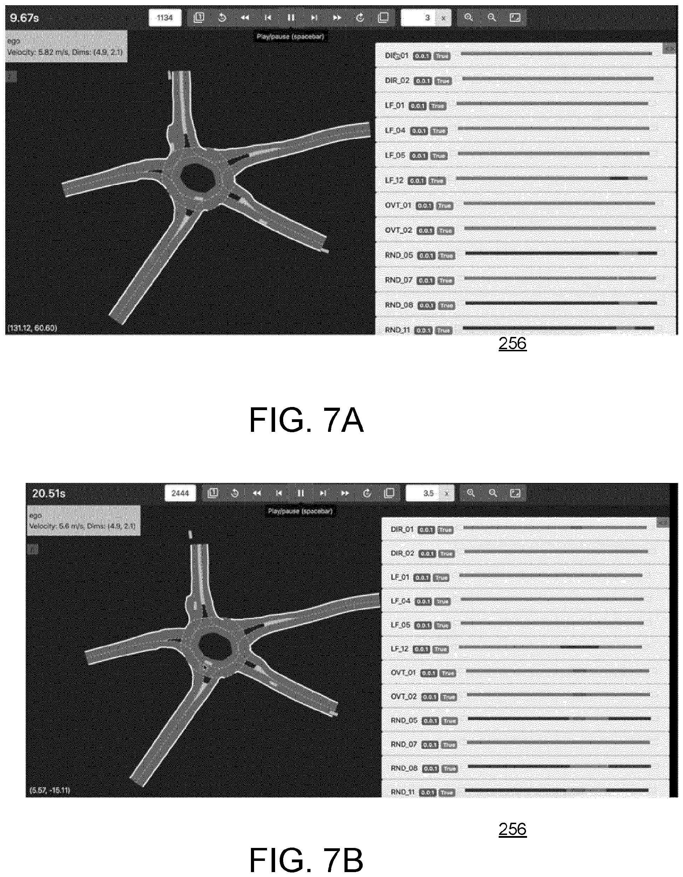

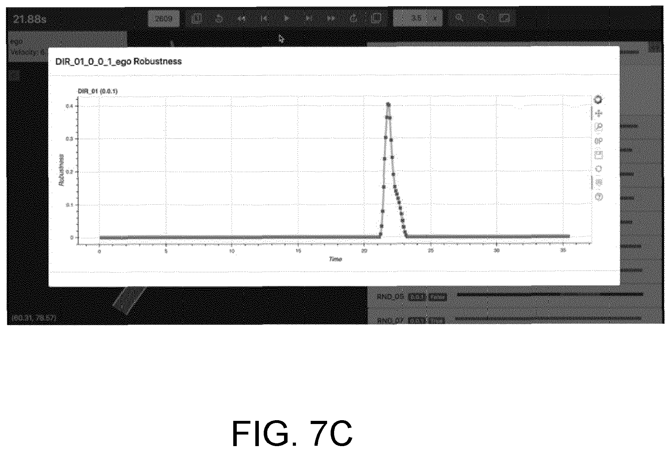

Figures 7A and 7B show examples of a testing interface on which such scores 256 are rendered, in associated with a visual representation of a scene to which they relate. Colour coding is used to indicate success/failure at different time intervals, based on the defined thresholds. Figure 7C shows how a numerical time plot of scores may be accessed for any given metric.

### Simulation application of ODDs

In the context of simulation, unless otherwise indicated, an ontological representation of a simulated scenario means an ontological representation of the *output* of the simulator 202, i.e. of the traces 212 generated by the simulator 202 and the associated environmental data 214. By contrast, the scenario description 201 is the *input* to the simulator 202. The outputs 212, 214 are partially determined by the inputted scenario description 201, but also by the decisions taken by the stack 100 under consideration, any decisions taken by the agent decision logic 210 (as applicable), and the responses of the agent dynamic models 202, 206. In other words, unless otherwise indicated, in the context of simulation, "scenario description" refers to the input to the simulator 202 on which a simulation is based, whereas "scenario representation" refers to an ontological representation of the output of the simulator 202 that would generally reflect agent dynamics, and in particular ego agent dynamics driven by decisions made within the stack 100 under testing during the simulation.

For the most basic form of ODD, it might be possible to classify a scenario as within or outside of the ODD solely on the basis of the scenario description 201. For example, with a basic geographic ODD constraint (e.g. restricting the ODD to a particular geographic region, as in the SAE J3016 examples above), if the scenario description 201 has some deterministic geographic parameter outside of this, that might mean that any scenario simulated on the basis of that scenario description necessarily be outside of the ODD, irrespective of how the simulated scenario actually plays out in the simulator 202.

However, a key benefit of the present framework is the ability to define the ODD in relation to the dynamics of a scenario. For example, it could be that a determining factor in whether or not the scenario is within the ODD is the behaviour of the ego agent itself, e.g. if the AV stack 100 makes some decision that then causes the ego agent to violate some minimum distance requirement relative to another vehicle (e.g. pulling out too close in front of another vehicle), the implementation of that decision by the ego agent will take the scenario outside of the ODD. This determination would be reached by analysing the relevant dynamic elements of the ontological representation of the scene (as extracted from the ego and agent traces 212a, 212b generated in the simulation) against the ontologically-defined ODD.

That is to say, a decision within the stack 100 would be what takes the scene outside of the ODD (or at least that decision could be a contributing factor). In this situation, perception error may also be pertinent, as the cause of that decision could be perception error (or at least perception error could be a contributing factor). With the pipeline architecture of Figure 2A, perception error is sampled from the perception error model(s) 208. A systematic and efficient way of assessing the relevance of perception error with this architecture is to repeat a simulation that fell outside of the ODD without perception error, i.e. based on the ground truth perception inputs 203G directly (keeping all other variables the same). If the resulting scene is now within the ODD, that result indicates that perception error was the cause of the original scene being outside of the ODD.

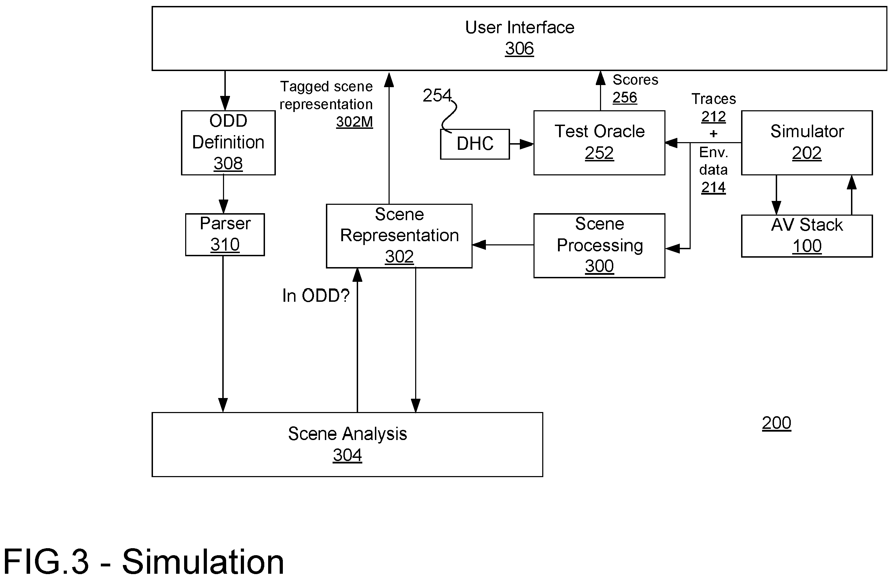

Figure 3 shows further details of the testing pipeline 200 in one example implementation. A user interface (UI) 306 receives user inputs from and outputs information to a user. Via the UI 306, the user can access the results generated by the test oracle 252, such as the scores 256 against the performance metrics 254 for a particular scenario. These scores are computed from the traces 212 and environmental data 214 in the manner described above.

In addition, a scene processor 300 processes the traces 212 and the environmental data 214 in order to extract an ontological representation of the scene 302. The principles of scene ontology are laid out in detail above, and are not repeated here. In summary, the ontological scene representation 302 is a relatively-high level representation of both static and dynamic elements of the scene in a hierarchical ontology language. Dynamic elements can for example encompass ego behaviour (extracted from the ego trace 212a), behaviour of other agent(s) (extracted from the agent trace(s) 212b), and changing environmental conditions such as changing weather conditions (extracted from the environmental data 214). The scene processor 300 may also be referred to herein as a trace processing component 300, although the generation of the formal scene representation 302 may also take into account the environmental data 214 as described.

Via the UI 306, the user can generate an ODD definition 308, using the same ontology language as the scene representation 302. A text-based editor can be provided for this purpose, allowing the user to code the formal definition of the ODD, which is then parsed 310 according to the rules of the ontology language for processing within the testing pipeline 200. The output of the parser 310 is a hierarchical data structure, structed in accordance with the hierarchical ontology language.

As already discussed, using the same ontology language to represent scenes and ODDs allows fast and precise determinations to be made as to whether a scene is within the defined ODD. That determination is made by a scene analyser 304 (also referred to as a trace analyser, although as described below, this analysis can also take into account environmental elements of the scene). In the present example, this determination is made at the level of individual elements of the scene (or combinations of elements). That is, the scene analyser classifies individual elements/combinations of elements of the scene representation 302 as outside of the defined ODD, as applicable. A "tagged" scene representation 302M, in which any elements/combinations outside of the defined ODD are visually marked (tagged), is rendered available to the user via the UI 306.

As a simple example, the ODD definition 306 might restrict the ODD to a particular subset of lighting or weather conditions. In this case, particular lighting or weather elements (which could be static or dynamic depending on the implementation details) of the scene representation 302 might be tagged as taking the scene 302 outside of the defined ODD. As another example, ODD definition 306 might restrict the ODD to particular traffic conditions, and dynamic traffic elements of the scene representation 302 (derived from the traces 212) could be tagged as taking the scene outside of the defined ODD.

As already discussed, using the same hierarchical ontology language to both formalize the ODD and represent scenes allow a precise and efficient determination to be made as to whether a scene or its elements are outside of the formal ODD. The ODD is a strictly defined subset of the ontology, and the scene representation 302 can be readily classified as within or outside of that subset by matching elements of the scene representation 302 to corresponding elements of the formal ODD definition 308. Those correspondences are straightforward to ascertain because the same ontology language is used for both.

Further examples are provided below, to further illustrate how an ontological scene representation can be mapped to an ODD definition in this manner.

The parsing of the ODD definition 308 also facilitates internal consistency checks, e.g. if the ODD is defined in a way that violates a hierarchy of the underlying ontology. This can be communicated to the user via the UI 306, e.g. by applying suitable mark up (visual tagging) to the ODD definition 308.

In simulation, the formal definition of the ODD 308 can be used to formulate a testing strategy, for testing a range of scenarios across the ODD.

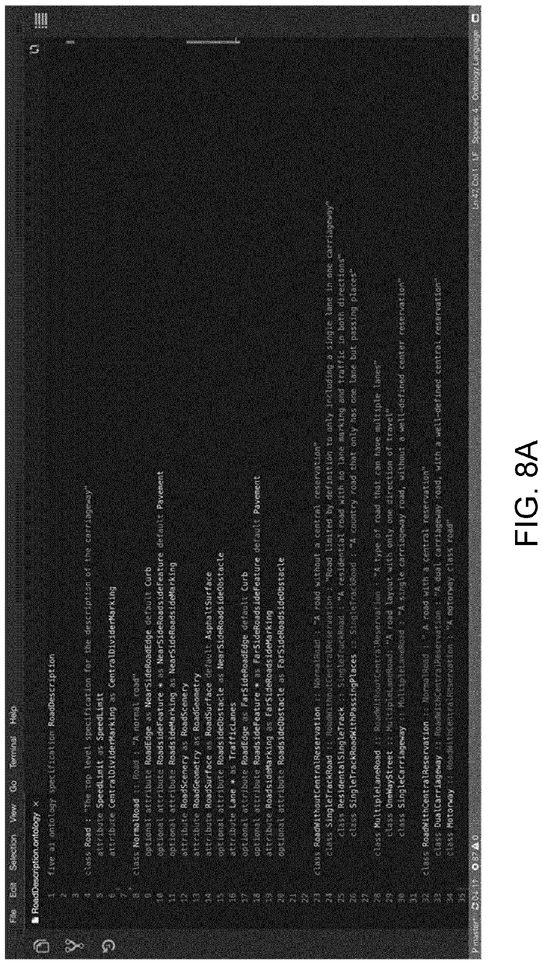

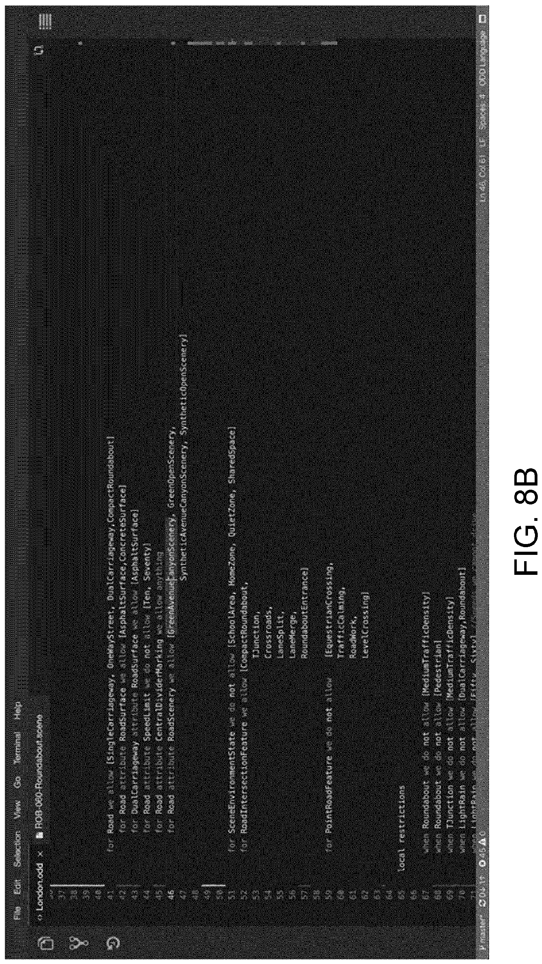

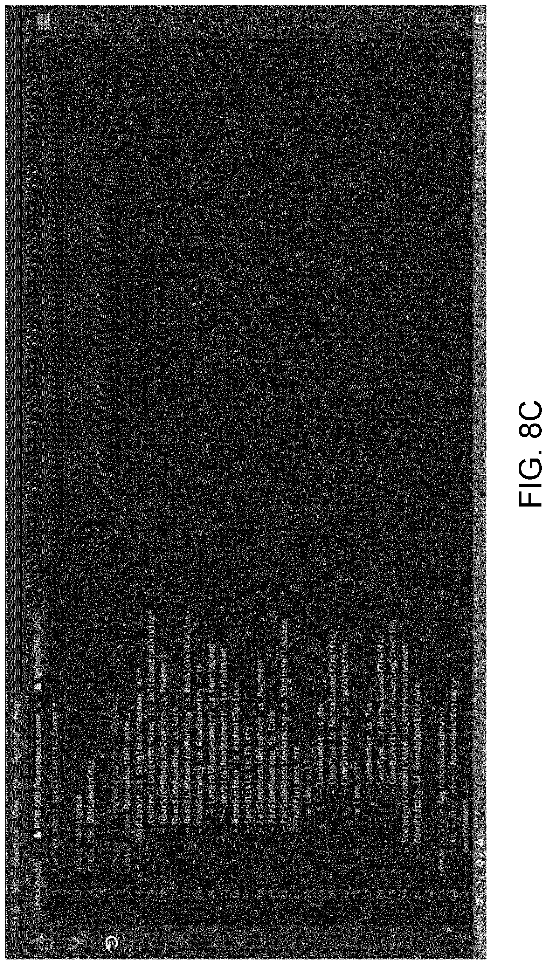

Figure 8A shows an example view rendered via the UI 306 for defining and editing road elements of an ontology (RoadDescription.ontology). Figures 8B and 8S show views, respectively, of an ODD (London.odd) and formal scene representation (ROB-060-Roundabout. scene) in the same ontology language. The ODD of Figure 8B precisely defines a subset of the ontology that includes the road elements of Figure 8A, allowing the scene representation of Figure 8C to be precisely classed as within or outside the ODD of Figure 8B. The examples depicted in Figures 8A-C are considered in more detail in the worked example below.

The components 300, 304, 306, 310 of Figure 3 provide an Integrated Development Environment (IDE) for specifying a driving domain ontology. Although described above in a simulation context, the IDE can be usefully deployed in other contexts, including those described below.

### Real-world application of ODDs

### Offline:

Whilst the above considers simulated traces, a benefit of the present architecture is that it can be equally applied to real-world trace, captured from on-board sensor and/or other sources such as CCTV (close circuit television).

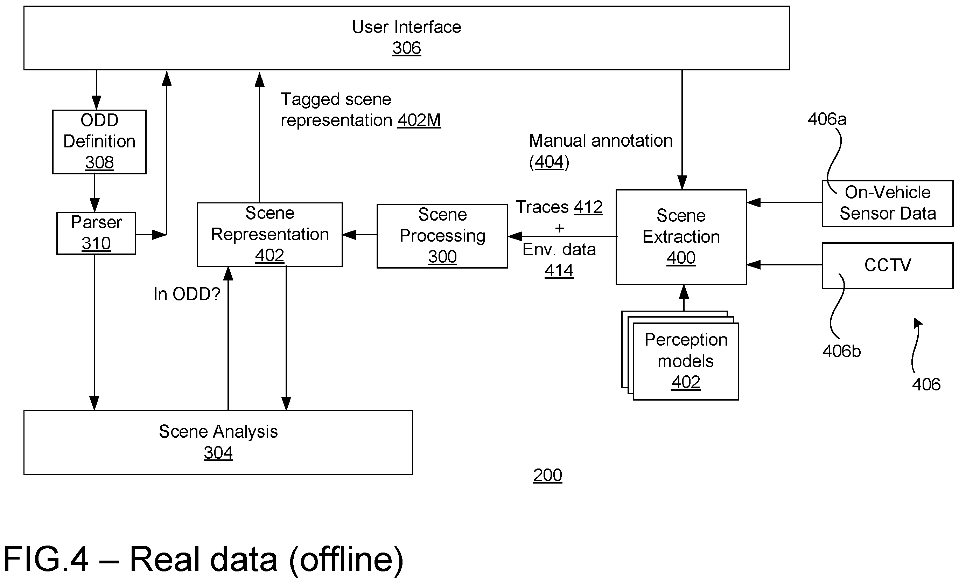

Figure 4 illustrates how the same techniques can be applied to real-world traces, in an offline context, within the testing pipeline 200.

A scene extraction component 400 receives real-world sensor data 406 about driving scenes (that is, real-world driving data), such as on-board sensor data 406a and/or CCTV 406b. The scene extraction component 400 processes the real-world driving data 406, in order to extract a set of traces 412 therefrom. This can be an automated process, using one or more perception models 402 applied to the driving data 406, a manual process where the traces are defined by manual annotation inputs 404 at the UI 306, or a semi-automated process using a combination of both. The extracted traces are then processed by the trace processing component 300 in exactly the same manner as the simulated traces 212 of Figure 3. The trace processing component 302 and scene analysis component 304 are agnostic as to the source of the traces (i.e. whether they are real or simulated). Exactly the same principles are applied, to extract an ontological scene representation 402 of a real-world driving scene, and to tag elements therefrom as outside of the ODD, as applicable, for rendering a tagged scene representation 402M via the UI 306. The same ODD definition 308 can be applied to real and simulated traces - this is similarly agnostic as to the source of the traces. Although not depicted in Figure 4, real-world environmental data can be extracted from the real-world sensor data as needed to generate the formal scene representation 402 .

### Online:

The present techniques can also be applied in an online context. In a real-world AV, an online application would equip the AV with the ability to make its own autonomous determination as to whether it is currently within or outside of a formally defined ODD. In the event it finds itself outside of the ODD, this would trigger a suitable event such as a drive alert or automated failover routine.

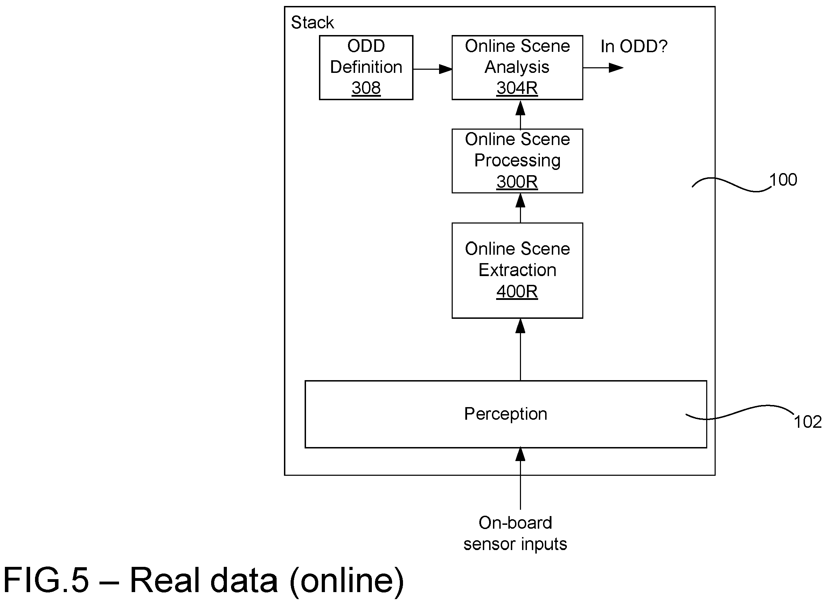

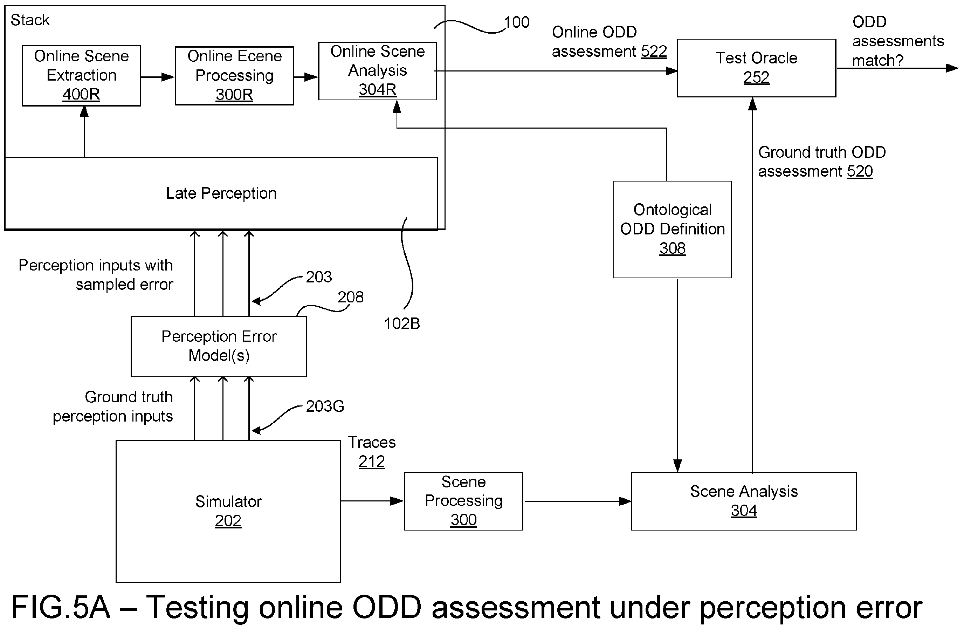

Figure 5 shows an example of an AV stack with such capabilities. The stack 100 is shown to comprise online scene extraction, trace processing and scene analysis components 400R, 300R, 304R. These operate in the same manner as described above, but in real-time within the AV stack 100. The online scene extraction component 400R processes outputs of the perception system, in order to extract traces and environmental data therefrom in real time. The real-time traces and environmental data are, in turn, processed by the online trace processing component 300R, to extract a formal ontological scene representation, which in turn is classified in real-time by the online scene analyser 304R, in relation to a formal ODD definition 308. As above, the ODD definition 308 and the online scene representation are encoded in the same ontology language as each other. The traces, environmental data, scene representation, and ODD classification results are updated in real-time as new perception outputs are generated by the perception system in response to on-board sensor inputs.

Another benefit of this approach is the alignment between simulation and online ODD assessment. This facilitates effective testing within the pipeline 200.

Figure 5A illustrates how the stack 100 of Figure 5 might be tested in the testing pipeline 200. In this case, the online components 400R, 300R, 304R of the stack 100 are ultimately responding to simulated perception inputs 203 provided by the simulator 202.

The function of Figure 3 are implemented in parallel, using the same ODD definition 308 as the online components 400R, 300R, 304R of the stack 100 itself: the simulated traces are processed by the trace processing component 300 of the testing pipeline 200 and the resulting ontological scene representation is provided to the scene analyser 304 of the testing pipeline 200 which classifies that output in relation the defined ODD (online ODD assessment 522).

A function of the test oracle 252 in this context is to compare the online ODD classification results made within the stack 100 - which could be incorrect if the stack 100 is not operating as intended during simulation - with the ODD classification results from the scene analyser 304 on the basis of the simulated traces 212 (which may be referred to as a "ground truth" ODD assessment 522 to distinguishing from the online ODD assessment 520 made within the stack 100 under testing).

This particular example uses perception error model(s) 208 to provide simulated perception inputs 203 with sampled perception error. It might be that the cause of an incorrect online ODD assessment 522 is perception error. As described above, perception error can be identified as the cause of an incorrect ODD classification by running the same simulated scenario, without perception error, based on the ground truth perception inputs 203G directly, and checking if the same error occurs.

### Metrics applied to scene representation:

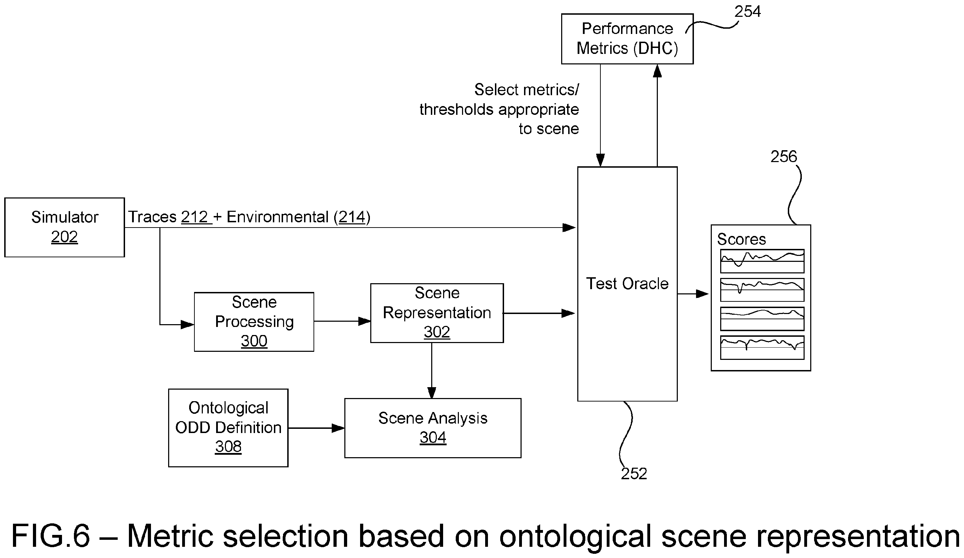

Figure 6 shows how an ontological scene representation 302 extracted from simulated traces can also be applied in the context of the metric-based assessment by the test oracle 252. That scene representation can be used by the test oracle 252 to determine what performance metrics to apply to a given scene (e.g. to select an appropriate subset of the performance metrics 254 for a particular scenario and/or to adapt the metrics), and/or to set their associated failure thresholds. For example, metrics/thresholds may be adapted in dependence on (potentially dynamic) whether or lighting conditions.

In this context, the scene representation 302 is used both to determine the performance metrics/threshold, and to assess the scene in relation to the formal ODD definition 308.

### IDE - worked example:

A worked example is set out below, demonstrating how the described IDE might be used in practice to specify a driving domain ontology, ODDs, and "scenes" AKA scenarios in that domain ontology. These are coded in a formal, hierarchical ontology language that is interpreted and applied within the system in the manner described above.

At the top level, a "world scene" is defined, which defines an instant snapshot of a scenario:

```
     WorldScene.ontology
     five ai ontology specification WorldScene
     class WorldScene : "The top level class for specifying the ODD-
     type scene for an EGO"
          attribute EgoState as EgoState
          attribute EnvironmentalState as EnvironmentalState
          attribute RoadStructure as RoadStructure
          attribute ActiveRoadState as ActiveRoadState
```

An environmental part of the ontology is defined hierarchically. The definition is based on real-world (or simulated) values, such as weather and other environmental conditions:

```
     EnvironmentalState.ontology
     five ai ontology specification EnvironmentalState
     class EnvironmentalState : "The conditions associated with the
     state of the environment."
          attribute SkyCondition as SkyCondition
          attribute WeatherCondition as WeatherCondition
          attribute GroundCondition as GroundCondition
          optional attribute WindLevel as WindLevel default Calm
          optional attribute AirParticulateMatter as
     AirParticulateMatter default ClearAir
     class WeatherCondition : "The types of weather that the Five AI
     Ontology distinguishes"
          values type = number range = [0,) units = "mm/h"
          class ClearCalm :: WeatherCondition : "Dry weather with
     little wind"
               values type = number range = [0,0] units = "mm/h"
          class AdverseConditions :: WeatherCondition : "Conditions
     that adversely affect the vehicle"
               class Snow :: AdverseConditions : "Snowing"
                    values type = number range = (0,) units = "mm/h"
               class Sleet :: AdverseConditions : "Sleet Shower"
                    values type = number range = (0,) units = "mm/h"
               class Rain :: AdverseConditions : "A level of rain that
     requires some use of wipers"
                    values type = number range = (0,) units = "mm/h"
                    class LightRain :: Rain : "Light rain requiring
     intermittent wipers"
                         values subrange = (0,5]
                    class ModerateRain :: Rain : "Rain requiring
     regular wipers"
                         values subrange = (5,20)
                    class HeavyRain :: Rain : "Rain requiring high-
     speed wipers"
                         values subrange = [20,)
     class SkyCondition : "The state of the sky: sun position, time
     of day"
          values type = number range = [0,8] units = "okta"
          attribute SunPosition as SunPosition
          attribute TimeOfDay as TimeOfDay
          class ClearSkies :: SkyCondition : "Completely clear sky"
               values subrange = [0,1]
          class PartlyCloudy :: SkyCondition : "Up to half of the sky
     is covered in clouds"
               values subrange = (1,4]
          class Overcast :: SkyCondition : "Most or all of the sky is
     covered in clouds"
               values subrange = [5,8]
     class SunPosition : "The compass position of the sun"
          values type = number range = [0,360] units = "degrees"
          class SunFromEast :: SunPosition : "Morning sun"
               values subrange = (45,135]
          class SunFromSouth :: SunPosition : "Afternoon sun"
               values subrange = (135,225]
          class SunFromWest :: SunPosition : "Evening sun"
               values subrange = (225,315]
          class SunFromNorth :: SunPosition : "We ain't in the
     southern hemisphere"
               values subrange = (315,45]
     class TimeOfDay : "The classification of the day, given by sub
     position above horizon"
          values type = number range = [-90,90] units = "degrees"
          class Daylight :: TimeOfDay : "Light when the sun is
     completely up"
               values subrange = (6,90]
          class Twilight :: TimeOfDay : "civil or nautical twilight,
     when streetlights and road road users headlights are
                                               expected to be on but are not
     the main source of lighting"
               values subrange = (-12,6]
               attribute ArtificialLight as AdditionalLighting
          class Dark :: TimeOfDay : "astronomical twilight or night,
     with little/no streetlight and main source of lights are EGO's
     own and other road users headlights"
               values subrange = [-90,-12]
               attribute ArtificialLight as AdditionalLighting
          class ArtificialLight : "When the bulk of light for the EGO
     comes from artificial sources"
          class Streetlights :: ArtificialLight : "twilight or night
     where the main source of road lighting is streetlights"
          class Headlights :: ArtificialLight : "Mean source of light
     is EGO headlights"
               class RegularHeadlights :: Headlights : "main source of
     light is EGO regular beams"
               class FullBeamHeadlights :: Headlights : "main source
     of light is EGO high beams"
          class VehicleLighting :: ArtificialLight : "arti"
               class OverheadVehicleLights :: VehicleLighting: "scene
     light is dominated by lorry overhead lights"
               class BackVehicleLights :: VehicleLighting : "scene
     with vehicle back lights"
               class FrontVehicleLights :: VehicleLighting : "scene
     with vehicle front-lights affecting camera"
     /* The weather */
     class WindLevel : "The speed of the wind that may disturb
     dynamic object or EGO trajectory"
          values type = number range = [0,) units = "m/s wind speed"
          class Calm : "Very little wind affecting the vehicle"
               values subrange = [0,1)
          class LightWinds : "Light winds that move branches, but not
     greatly affecting the vehicle."
               values subrange = [1,10)
          class StrongWinds : "Strong winds that greatly affect the
     vehicle."
               values subrange = [10,)
     /* The Road Conditions */
     class GroundCondition : "The state of the road"
          class DryGround :: GroundCondition : "Dry road (independent
     of weather) - e.g. under a bridge the road could be dry"
          class IcyGround :: GroundCondition : "Ice on the road"
          class SnowyGround :: GroundCondition : "Snow on the ground
     where visibility of ground/lanes or control of vehicles is
     affected"
          class WetGround :: GroundCondition : "Liquid coverage on
     the ground"
               class NormalWetGround :: WetGround : "road is wet
     including small puddles that would not typically cause vehicle
     traction/splash issues or water-planing"
               class StandingWaterOnGround :: WetGround : "large
     puddles, or large bodies of standing water that could cause
     large splashes, water-planing or affect control of EGO"
               class FloodingOnGround :: WetGround : "road/lane
     flooding where typically reduced speed is required"
     /* Particulate Matter */
     class AirParticulateMatter : "The state of the air on the road
     that the vehicle is driving"
          class ClearAir :: AirParticulateMatter : "No abnormal air
     particulate detected."
          class Fog :: AirParticulateMatter : "Dry road (independent
     of weather) - e.g. under a bridge the road could be dry"
          class CarSmoke :: AirParticulateMatter : "smoke from cars
     (e.g. in cold winter morning)"
          class SensorParticulate :: AirParticulateMatter : "A
     particular type of particulate that *may* directly affect the
     sensors directly"
          class DustAirParticulate :: SensorParticulate : "dirt or
     dust in the air (e.g. from construction site)"
          class MudAirParticulate :: SensorParticulate : "mud sprays
     from vehicles, or splashes from standing water"
          class SprayAirParticulate :: SensorParticulate : "spray
     from vehicles or EGO vehicle"
```

As can be seen, the ontology allows environmental classes to be defined hierarchically. The above example defines the following "top-level" classes: weather, sky condition, sun position, time of day, wind level, road conditions and particulate matter. Further sub-classes can then be defined hierarchically, in the manner shown. The language allows classes and sub-classes to be mapped onto ranges of numerical measurements (environmental variables).

Within the IDE, internal consistency checks are applied to the environmental definition. For example, these could automatically flag when a sub-class (child class) of a higher-level class (parent class) is mapped to a range of a particular environmental variable that is inconsistent with the parent class.

The sample principles apply to visible road elements, with hierarchical road structure classes similarly mapped to numerical road variables:

```
     RoadDescription.ontology
     five ai ontology specification RoadDescription
     class Road : "The top level specification for the description
     of the carriageway"
          attribute SpeedLimit as SpeedLimit
          attribute CentralDividerMarking as CentralDividerMarking
     class NormalRoad :: Road : "A normal road"
          optional attribute RoadEdge as NearSideRoadEdge default
     Curb
          optional attribute RoadsideFeature * as
     NearSideRoadsideFeature default Pavement
          optional attribute RoadsideMarking as
     NearSideRoadsideMarking
          attribute RoadScenery as RoadScenery
          attribute RoadGeometry as RoadGeometry
          attribute RoadSurface as RoadSurface default AsphaltSurface
          optional attribute RoadsideObstacle as
     NearSideRoadsideObstacle
          attribute Lane * as TrafficLanes
          optional attribute RoadEdge as FarSideRoadEdge default Curb
          optional attribute RoadsideFeature * as
     FarSideRoadsideFeature default Pavement
          attribute RoadsideMarking as FarSideRoadsideMarking
          optional attribute RoadsideObstacle as
     FarSideRoadsideObstacle
     class RoadWithoutCentralReservation :: NormalRoad : "A road
     without a central reservation"
          class SingleTrackRoad :: RoadWithoutCentralReservation :
     "Road limited by definition to only including a single lane in
     one carriageway"
               class ResidentalSingleTrack :: SingleTrackRoad : "A
     residential road with no lane marking and traffic in both
     directions"
               class SingleTrackRoadWithPassingPlaces ::
     SingleTrackRoad : "A country road that only has one lane but
     passing places"
          class MultipleLaneRoad :: RoadWithoutCentralReservation :
     "A type of road that can have multiple lanes"
               class OneWayStreet :: MultipleLaneRoad: "A road layout
     with only one direction of travel"
               class SingleCarriageway :: MultipleLaneRoad : "A single
     carriageway road, without a well-defined center reservation"
     class RoadWithCentralReservation :: NormalRoad : " A road with
     a central reservation"
          class DualCarriageway :: RoadWithCentralReservation : "A
     dual carriageway road, with a well-defined central reservation"
          class Motorway :: RoadWithCentralReservation : "A motorway
     class road"
          class Roundabout :: Road : "A roundabout road type"
          attribute RoadFeature as EgoEntrance
          attribute ArmDescription * as RoundaboutArms
          attribute Lane * as RoundaboutLanes
          class NormalRoundabout :: Roundabout: "A roundabout with a
     kerbed central island at least 4 m in diameter and dual-lane "
          class LargeRoundabout :: Roundabout: "A roundabout with a
     kerbed central island at least 4 m in diameter and more than 4
     arms"
          class CompactRoundabout :: Roundabout: "A roundabout with
     single-lane entry "
          class MiniRoundabout :: Roundabout: "A roundabout without a
     kerbed central island. Instead of kerbed central island there
     is a circulatory road marking 1 to 4 m in diameter"
          class SignalledRoundabout :: Roundabout : "A roundabout
     with signals controlling access"
     class Lane : "An individual lane of traffic"
          attribute LaneDirection as LaneDirection
          attribute Number as LaneNumber
          optional attribute LaneType as LaneType default
     NormalLaneOfTraffic
          optional attribute LaneSpecialFeature as LaneSpecialFeature
     class ArmLocation : "The roundabout arm"
          values type = number range = [0,360) units = "degrees"
          class FirstQuarter :: ArmLocation : "Near ego entrance"
               values subrange = [0,90)
          class SecondQuarter :: ArmLocation : "Near ego entrance"
               values subrange = [90,180)
          class ThirdQuarter :: ArmLocation : "Near ego entrance"
               values subrange = [180,270)
          class FinalQuarter :: ArmLocation : "Furtherst point"
               values subrange = [270,360)
      class ArmDescription : "A roundabout arm"
          attribute Number as ArmNumber
          attribute ArmLocation as ArmLocation
          attribute Lane * as LanesInArm
```

The above component (WorldScene . ontology, EnvironmentalState . ontology and RoadDescription. ontology) are components of the ontology itself, i.e. these define the world in terms of hierarchical classes mapped to numerical variables.

The ODD is a subset of the ontology, i.e. the subset of the world in which an AV can safely operate. The following shows how an ODD may be defined in the same ontology language for a particular city, such as London (UK):

```
London.odd
     five ai odd definition London
     default is permissive
     //Any ontology element not explicitly mentioned will be
     accepted as part of the ODD
     global definitions
          for GenericTrafficDensity we allow [LowTrafficDensity,
     MediumTrafficDensity]
          for ActiveRoadState attribute PertinentSceneElements we do
     not allow [LearnerOrNewDriverCar,
                                                WideLoadLorry,
                                                ArticulatedBus,
                                                 EmergencyVehicle,
                                                 Cyclist,
                                                HorseRider,
                                                NonRoadRespectingObjects]
          for AirParticulateMatter we allow [ClearAir]
          for WeatherCondition we allow [ClearCalm, LightRain]
          for TimeOfDay we allow [Daylight]
          for TimeOfDay we do not allow [Twilight, Dark]
          for WindLevel we do not allow [StrongWinds]
          for GroundCondition we allow [DryGround, WetGround]
          for AlteredCondition we do not allow anything
          for FunctionalManoeuvre we allow [SettingOff,
                                                       LaneFollowing,
     VehicleDistanceModeration,
                                                       StopAndWait,
                                                       LeftTurnMinorToMajor,
                                                       LeftTurnMajorToMinor,
                                                       RoundaboutExit,
                                                       EnterRoundabout,
     OvertakeSingleCarriageway]
          for NonFunctionalManoeuvre we allow
     [DisplayIndicatorLights]
          for Road we allow [SingleCarriageway, OneWayStreet,
     DualCarriageway,CompactRoundabout]
               for Road attribute RoadSurface we allow
     [AsphaltSurface,ConcreteSurface]
               for DualCarriageway attribute RoadSurface we allow
     [AsphaltSurface]
               for Road attribute SpeedLimit we do not allow [Ten,
     Seventy]
               for Road attribute CentralDividerMarking we allow
     anything
               for Road attribute RoadScenery we allow
     [GreenAvenueCanyonScenery, GreenOpenScenery,
     SyntheticAvenueCanyonScenery, SyntheticOpenScenery]
          for SceneEnvironmentState we do not allow [SchoolArea,
     HomeZone, QuietZone, SharedSpace]
          for RoadIntersectionFeature we allow [CompactRoundabout,
                                                            TJunction,
                                                            Crossroads,
                                                            LaneSplit,
                                                            LaneMerge,
                                                            RoundaboutEntrance]
          for PointRoadFeature we do not allow
     [EquestrianCrossing,
                                                            TrafficCalming,
                                                            RoadWork,
                                                            LevelCrossing]
     local restrictions
          when Roundabout we do not allow [MediumTrafficDensity]
          when Roundabout we do not allow [Pedestrian]
          when TJunction we do not allow [MediumTrafficDensity]
          when LightRain we do not allow [DualCarriageway,Roundabout]
          when LightRain we do not allow [Fifty, Sixty] //Speeds we
     cannot drive
```

The "default" setting in the above is a specific mechanism for parts of ontology not explicitly defined, where any element of the ontology that is not explicitly mentioned will form part of the ODD. Another option is restrictive, where any element of the ontology that is not explicitly falls outside of the ODD.

An intuitive syntax is provided for defining elements in relation to single dimensions and attributes.

Consistency checks are applied to the ODD definition within the pipeline 200, in order to detect and flag an internal inconsistencies in the ODD.

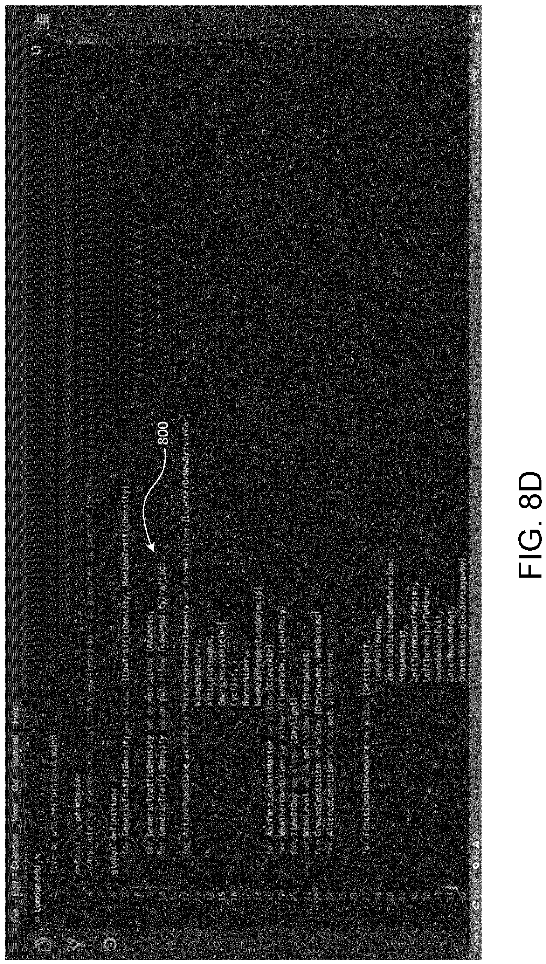

Figure 8D shows a possible view provided by the UI 306, on which text of the London. odd ontology is rendered. In this example, second and third conditions have been attached to the GenericTrafficDensityelement, in addition to the first condition embodied in the code above:

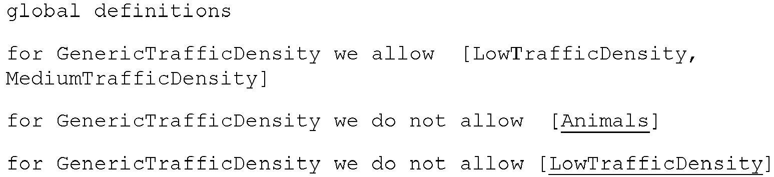

As indicated by reference numeral 800, the second condition has been automatically detected and visually marked as inconsistent (via wavy underlining), because "Animals" is not a traffic density; the third condition has been similarly detected and marked as inconsistent, because the first condition allows low density traffic (i.e. defines it as within the ODD), and the second does not allow it (i.e. defines it as outside of the ODD) - low density traffic cannot be allowed and not allowed.

Hierarchy is respected within the ODD definition. The syntax element "anything" allows or disallows all subclasses.

In the above, "EmergencyVehicle" is not a leaf class, i.e. it has further sub-classes, all of which are excluded from the ODD in this example.

This framework provides sophisticated semantics for attributes with respect to hierarchy. The above ODD has a section that that limits the ODD based on road conditions:

```
          for Road we allow [SingleCarriageway, OneWayStreet,
     DualCarriageway,CompactRoundabout]
               for Road attribute RoadSurface we allow
     [AsphaltSurface,ConcreteSurface]
               for DualCarriageway attribute RoadSurface we allow
     [AsphaltSurface]
```

The effect of the second and third conditions is to allow asphalt and concrete surface for all of the allowed roads types except dual carriageway (i.e. for single carriageways, one way streets and compact roundabouts); for dual carriageway, only asphalt surface is allowed (concrete dual carriageways are outside of the ODD).

Fine-grained control of the ODD is provided via "local restrictions". Some explanation of certain local restrictions defined in the above ODD code follows.

A first local restriction is as follows:

```
          when Roundabout we do not allow [MediumTrafficDensity]
```

This local restriction excludes roundabouts with medium traffic density from the ODD; with the earlier global definition that restricts traffic density to light and medium, i.e.

```
           for GenericTrafficDensity we allow [LowTrafficDensity,
     MediumTrafficDensity]
```

the combined effect is that only roundabouts with low traffic density are within the defined ODD.

A second local restriction is:

```
          when Roundabout we do not allow [Pedestrian]
```

Roundabouts at which one or more pedestrians are present therefore fall outside of the ODD.

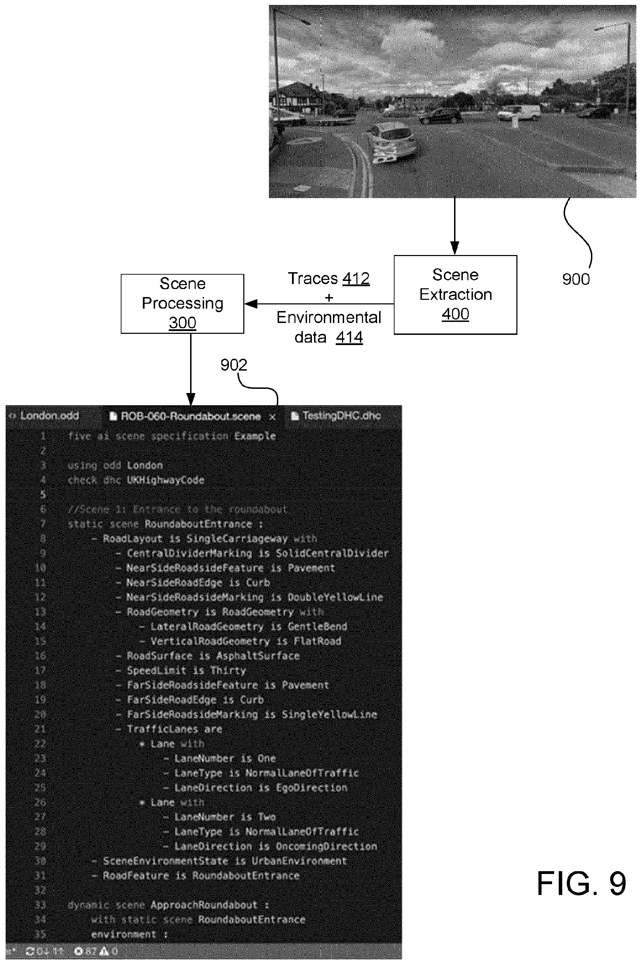

Figure 9 provides a highly schematic overview of the mapping between real or simulated data capturing a dynamic roundabout scene 900 and a formal scene representation 902 generated by the scene processing component 300, based on traces and environmental data extracted from the data 900.

The scene representation 902 includes static and dynamic components, expressed in the ontology language as follows:

```
     ROB-060-Roundabout.scene
     five ai scene specification Example
     using odd London
     check dhc UKHighwayCode
     //Scene 1: Entrance to the roundabout
     static scene RoundaboutEntrance :
          - RoadLayout is SingleCarriageway with
               - CentralDividerMarking is SolidCentralDivider
               - NearSideRoadsideFeature is Pavement
               - NearSideRoadEdge is Curb
               - NearSideRoadsideMarking is DoubleYellowLine
               - RoadGeometry is RoadGeometry with
                    - LateralRoadGeometry is GentleBend
                    - VerticalRoadGeometry is FlatRoad
               - RoadSurface is AsphaltSurface
               - SpeedLimit is Thirty
               - FarSideRoadsideFeature is Pavement
               - FarSideRoadEdge is Curb
               - FarSideRoadsideMarking is SingleYellowLine
               - TrafficLanes are
                    * Lane with
                         - LaneNumber is One
                         - LaneType is NormalLaneOfTraffic
                         - LaneDirection is EgoDirection
                    * Lane with
                         - LaneNumber is Two
                         - LaneType is NormalLaneOfTraffic
                         - LaneDirection is OncomingDirection
          - SceneEnvironmentState is UrbanEnvironment
          - RoadFeature is RoundaboutEntrance
     dynamic scene ApproachRoundabout :
          with static scene RoundaboutEntrance
          environment :
               - SkyCondition is ClearSkies with
                    - SunPosition is SunFromSouth
                    - TimeOfDay is Twilight
               - WeatherCondition is ClearCalm
               - GroundCondition is DryGround
          active road :
               - GenericTrafficDensity is MediumTrafficDensity
               - PertinentSceneElements are
                    * Car
                    * Lorry
          ego state :
               - EgoManoeuvre is EnterRoundabout with
                    - LaneNumber is One
     dynamic scene EnterRoundabout :
          with static scene RoundaboutEntrance
          environment :
               - SkyCondition is ClearSkies with
                    - SunPosition is SunFromSouth
                    - TimeOfDay is Daylight
               - WeatherCondition is ClearCalm
               - GroundCondition is DryGround
          active road :
               - GenericTrafficDensity is LowTrafficDensity
               - PertinentSceneElements are
                    * Car
                    * Bus
          ego state :
               - EgoManoeuvre is VehicleDistanceModeration with
                    - LaneNumber is One
                    - VehicleBeingFollowed is Car
     static scene Roundabout :
          - RoadLayout is CompactRoundabout with
               - CentralDividerMarking is NoCentralDividerMarking
               - SpeedLimit is Thirty
               - RoundaboutLanes are
                    * Lane with
                         - LaneNumber is One
                         - LaneType is NormalLaneOfTraffic
                         - LaneDirection is EgoDirection
               - RoundaboutArms are
                    * ArmDescription with
                         - ArmNumber is One
                         - ArmLocation is FirstQuarter
                         - LanesInArm are
                              * Lane with
                                   - LaneNumber is One
                                   - LaneType is NormalLaneOfTraffic
                                   - LaneDirection is EgoDirection
                              * Lane with
                                   - LaneNumber is Two
                                   - LaneType is NormalLaneOfTraffic
                                   - LaneDirection is OncomingDirection
                    * ArmDescription with
                         - ArmNumber is Two
                         - ArmLocation is SecondQuarter
                         - LanesInArm are
                              * Lane with
                                   - LaneNumber is One
                                   - LaneType is NormalLaneOfTraffic
                                   - LaneDirection is EgoDirection
                              * Lane with
                                   - LaneNumber is Two
                                   - LaneType is NormalLaneOfTraffic
                                   - LaneDirection is OncomingDirection
                    * ArmDescription with
                         - ArmNumber is Three
                         - ArmLocation is SecondQuarter
                         - LanesInArm are
                              * Lane with
                                   - LaneNumber is One
                                   - LaneType is NormalLaneOfTraffic
                                   - LaneDirection is EgoDirection
                              * Lane with
                                   - LaneNumber is Two
                                   - LaneType is BusLane
                                   - LaneDirection is OncomingDirection
                              * Lane with
                                   - LaneNumber is Three
                                   - LaneType is NormalLaneOfTraffic
                                   - LaneDirection is OncomingDirection
                    * ArmDescription with
                         - ArmNumber is Four
                         - ArmLocation is ThirdQuarter
                         - LanesInArm are
                              * Lane with
                                   - LaneNumber is One
                                   - LaneType is NormalLaneOfTraffic
                                   - LaneDirection is EgoDirection
                              * Lane with
                                   - LaneNumber is Two
                                   - LaneType is NormalLaneOfTraffic
                                   - LaneDirection is OncomingDirection
     dynamic scene EnterRoundabout :
          with static scene Roundabout
          environment :
               - SkyCondition is ClearSkies with
                    - SunPosition is SunFromSouth
                    - TimeOfDay is Daylight
               - WeatherCondition is ClearCalm
               - GroundCondition is DryGround
          active road :
               - GenericTrafficDensity is LowTrafficDensity
               - PertinentSceneElements are
                    * Car
          ego state :
               - EgoManoeuvre is TakeThirdExit with
                    - LaneNumber is One
                    - VehicleBeingFollowed is Car
```

As can be seen, the scene representation is event-driven in this example. As the scene progressed, new static and dynamic elements are added, reflecting the progress of the ego vehicle though the roundabout.

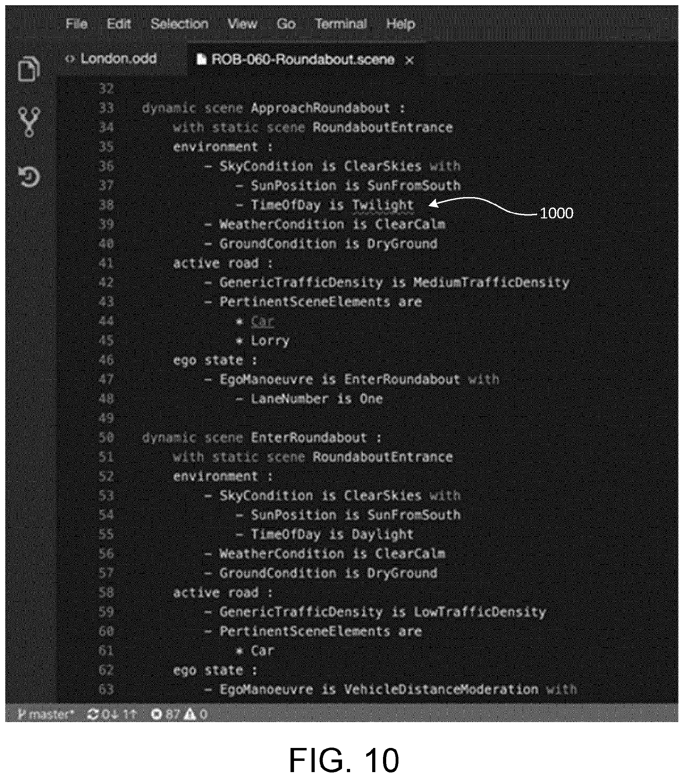

Figure 10 shows a possible rendering, by the UI 306, of the ROB- 0 60-Roundabout. scene scene representation, once it has been analyzed against the London. odd operational design domain.

For the RoundaboutEntrance section of the scene, the time of day has been identified as "Twilight", as indicated by reference numeral 1000. However, according to the global definitions of the ODD set out above, this falls outside of the ODD:

```
     global definitions
          for TimeOfDay we allow [Daylight]
          for TimeOfDay we do not allow [Twilight, Dark]
```

This is automatically detected, and the "Twilight" element of the scene representation has been visually marked as taking the scene outside of the ODD.

References herein to components, functions, modules and the like, denote functional components of a computer system which may be implemented at the hardware level in various ways. A computer system comprises one or more computers that may be programmable or non-programmable. A computer comprises one or more processors which carry out the functionality of the aforementioned functional components. A processor can take the form of a general-purpose processor such as a CPU (Central Processing unit) or accelerator (e.g. GPU) etc. or more specialized form of hardware processor such as an FPGA (Field Programmable Gate Array) or ASIC (Application-Specific Integrated Circuit). That is, a processor may be programmable (e.g. an instruction-based general-purpose processor, FPGA etc.) or non-programmable (e.g. an ASIC). Such a computer system may be implemented in an onboard or offboard context

## Claims

1. A computer system for analysing driving scenes in relation to an autonomous vehicle (AV) operational design domain (ODD), the computer system comprising:
an input configured to receive a definition of the ODD in a formal ontology language;
a scene processor configured to receive data of a driving scene and extract a scene representation therefrom, the data comprising an ego trace, at least one agent trace, and environmental data about an environment in which the traces were captured or generated, wherein the scene representation is an ontological representation of both static and dynamic elements of the driving scene extracted from the traces and the environmental data, and expressed in the same formal ontology language as the ODD; and
a scene analyzer configured to match the static and dynamic elements of the scene representation with corresponding elements of the ODD, and thereby determine whether or not the driving scene is within the defined ODD.

2. The computer system of claim 1, comprising a simulator configured to simulate the driving scene, the traces being simulated traces of the simulated driving scene.

3. The computer system of claim 2, wherein the simulator is configured to provide simulated perception inputs to a full or partial AV stack, and simulate the ego trace to reflect decisions taken by the AV stack in response to the simulated perception inputs.

4. The computer system of claim 1, comprising a scene extraction component configured to extract the data of the driving scene from real-world sensor data.

5. The computer system of claim 4, wherein the scene extraction component is configured to extract the data of the driving scene using one or more perception models applied to the sensor data and/or based on manual annotation inputs.

6. The computer system of any preceding claim, wherein the scene analyser is configured to identify an individual element or a combination of elements of the scene representation as outside of the ODD.

7. The computer system of claim 6, comprising a user interface configured to display the scene representation with a visual indication of any individual element or combination of elements identified to be outside of the ODD.

8. The computer system of claim 5 or any claim dependent thereon, comprising an input configured to receive sensor data in one or more data streams, the computer system configured to operate in real-time;
wherein, optionally, the computer system is embodied in a physical autonomous vehicle for making an online determination as to whether or not the physical autonomous vehicle is within the ODD.

9. The computer system according to claim 3 or any claim dependent thereon, wherein the AV stack includes an online scene analyzer configured to make a separate online determination as to whether or the driving scene is within the ODD, based on the simulated perception inputs;
wherein the computer system is configured to determine whether or not the determination by the scene analyzer matches the online determination within the AV stack or sub-stack.

10. The computer system of claim 3 or any claim thereon, wherein the AV stack is a partial AV stack, wherein the simulator provides ground truth perception inputs, but the perception inputs inputted to the partial AV stack contain perception errors sampled from one or more perception error models.

11. The computer system of claims 9 and 10, wherein, in the event that the online determination as to whether the scene is within the ODD does not match the determination by the scene analyzer, the computer system is configured repeat the simulation based on the ground truth perception inputs directly, without any sampled perception errors, to ascertain whether or not the mismatch was caused by the perception errors.

12. The computer system of claim 10 or any claim dependent thereon, wherein in the event the scene analyzer determines the scene is outside of the ODD, the computer system is configured to do at least one of:
ascertain whether or not a decision(s) within the AV stack caused the scene to be outside of the ODD, and
repeat the simulation based on the ground truth perception inputs directly, without any sampled perception errors, to ascertain whether or not the perception errors caused the scene to be outside of the ODD.

13. The computer system of claim 2 or any claim dependent thereon, comprising a test oracle configured to apply a set of numerical performance metrics to score the performance of the AV stack on the simulated driving scene;
wherein the test oracle is configured to select at least one of the set of numerical performance metrics, and a set of thresholds applied to the numerical performance metrics, based on one or more of the static and/or dynamic elements of the scene representation.

14. A computer-implemented method of analysing driving scenes in relation to an autonomous vehicle (AV) operational design domain (ODD), the method comprising:
receiving a definition of the ODD in a formal ontology language;
receiving data of a driving scene and extracting a scene representation therefrom, the data comprising an ego trace, at least one agent trace, and environmental data about an environment in which the traces were captured or generated, wherein the scene representation is an ontological representation of both static and dynamic elements of the driving scene extracted from the traces and the environmental data, and expressed in the same formal ontology language as the ODD; and
matching the static and dynamic elements of the scene representation with corresponding elements of the ODD, and thereby determining whether or not the driving scene is within the defined ODD.

15. A computer program comprising program instructions for programming a computer system to implement the components or method of any preceding claim.
